# EUROPÄISCHE PATENTSCHRIFT

(11) **EP 4 066 277 B1**
(45) Veröffentlichungstag und Bekanntmachung des Hinweises auf die Patenterteilung: **01.11.2023**
(21) Anmeldenummer: 21701918.1
(22) Anmeldetag: 14.01.2021
(51) Int. Cl.: H01L 21/48, H01L 23/367, H05K 7/20, H01L 23/373

(54) **VERFAHREN ZUR HERSTELLUNG EINER LEISTUNGSMODULEINHEIT**
METHOD FOR MANUFACTURING A POWER MODULE UNIT
PROCÉDÉ DE FABRICATION D'UNE UNITÉ DE MODULE DE PUISSANCE

(30) Priorität: 28.02.2020 EP 20160146
(43) Veröffentlichungstag der Anmeldung: 05.10.2022
(73) Patentinhaber: Siemens Aktiengesellschaft, 80333 München (DE)
(72) Erfinder: KAPPAUF, Daniel, 91322 Gräfenberg (DE); PANICERSKI, Stanislav, 90449 Nürnberg (DE); SCHMENGER, Jens, 91301 Forchheim (DE)
(74) Vertreter: Siemens Patent Attorneys
(86) Internationale Anmeldenummer: PCT/EP2021/050622
(87) Internationale Veröffentlichungsnummer: WO 2021/170308

(56) Entgegenhaltungen:
- EP-A1- 1 133 793
- JP-A- H1 131 771
- US-A1- 2005 199 371
- US-A1- 2018 087 846

## Beschreibung

Die Erfindung betrifft ein Verfahren zur Herstellung einer Leistungsmoduleinheit.

Ferner betrifft die Erfindung einen Kühlkörper für eine Leistungsmoduleinheit.

Überdies betrifft die Erfindung eine Leistungsmoduleinheit, welche mindestens einen derartigen Kühlkörper aufweist.

Darüber hinaus betrifft die Erfindung einen Umrichter, welcher mindestens eine derartige Leistungsmoduleinheit aufweist.

Leistungsmodule umfassen in der Regel ein Substrat mit einem Leistungshalbleiter, beispielsweise einem IGBT (Insulated-Gate Bipolar Transistor), welcher auf einem Substrat fest verbunden ist. Das Substrat weist auf beiden Seiten eine Metallstruktur auf, wobei die Metallstruktur auf der einen Seite zur Verbindung mit dem Leistungshalbleiter ausgebildet ist und auf der anderen Seite auf einer Grundplatte befestigbar ist.

Die Grundplatte wird gemäß derzeitigem Stand der Technik vorzugsweise mit einer wärmeleitenden Struktur beaufschlagt und auf einem Kühlkörper befestigt. Um thermische Effekte auszugleichen, ist eine komplexe Vorbiegung der Grundplatte notwendig, so dass die Grundplatte auch bei einer Temperatur von mehr als 100 Grad Celsius fest mit dem Kühlkörper verbunden ist. Eine Einheit, umfassend ein Leistungsmodul und ein Kühlkörper, wird hier als Leistungsmoduleinheit bezeichnet.

Bisher werden Kühlkörper gemäß Stand der Technik gegossen oder mittels Strangpressen hergestellt.

Die Offenlegungsschrift DE 3518310 A1 beschreibt einen Kühlkörper für Halbleiterbauelemente, insbesondere aus stranggepreßtem Leichtmetall, mit in Abstand zueinander von einer Grundplatte abragenden Kühlrippen etwa stabartigen Querschnittes, wobei die Grundplatte an einer Oberfläche Hauptnuten aufweist, in welchen jeweils eine Kühlrippe mit einem Sockel durch Verformung der dem Sockel nahegelegenen Teile der Grundplatte festgelegt ist.

Die Offenlegungsschrift DE 10 2015 202 196 A1 beschreibt ein Verfahren zur Herstellung eines Kühlkörpers für einen Frequenzumrichter, wobei der Kühlkörper einen Grundkörper mit einem Kühlluftkanal und eine Anzahl von Kühlrippen aufweist, wobei die Kühlrippen in dem Kühlluftkanal angeordnet sind. Das Verfahren weist die Schritte auf: Herstellen der Kühlrippen, Einlegen der Kühlrippen in ein Gießwerkzeug, wobei das Gießwerkzeug die Form des Grundkörpers definiert, und Einbringen einer Metallschmelze in das Gießwerkzeug zum Herstellen des Grundkörpers und zum Erzeugen einer stoffschlüssigen Verbindung zwischen dem Grundkörper und den Kühlrippen.

Die Offenlegungsschrift DE 10 2006 038 980 A1 beschreibt einen Kühlkörper für Halbleiterbauelemente mit in Abstand zueinander an eine Grundplatte angeschlossenen und davon aufragenden Kühlrippen, die jeweils als Hohlprofil mit zwei zueinander parallelen Rippenwänden und diese verbindenden Querstegen ausgebildet sind sowie in Einsatznuten o. dgl. Ausnehmungen der Grundplatte festliegen. Jede Rippenwand der Kühlrippe weist ein freies Steckende auf, das in eine Einsatznut der Grundplatte einbringbar ist. Die die Einsatznut begrenzenden Leistenanformungen ragen von der Oberfläche der Grundplatte und sind von unterschiedlicher Höhe. Die beiden Steckenden der Kühlrippe sind durch einen angeformten Quersteg verbunden, dessen Abstand zur Fußkante des Steckendes kürzer ist als der Abstand der Kopffläche einer ihm zugeordneten Leistenanformung der Grundplatte vom Tiefsten der Einsatznut.

Die Offenlegungsschrift US 2005/199371 A1 beschreibt ein Verfahren zur Herstellung eines Kühlkörpers, bei dem eine Metallbasis erhitzt wird, um Lot in den in der Basis gebildeten Rillen zu schmelzen. Die Basis hat einen ersten Wärmeausdehnungskoeffizienten. Das Lot hat einen zweiten thermischen Ausdehnungskoeffizienten, der niedriger ist als der erste thermische Ausdehnungskoeffizient. Der Metallträger und das Lot werden abgekühlt und der Metallträger erfährt Zugspannungen und das Lot erfährt Druckspannungen, um eine Konkavität in einer thermischen Fläche des Trägers zu bilden. Die thermische Fläche wird dann gehobelt. Mit der Zeit nehmen die Zug- und Druckspannungen ab, so dass die Wärmefläche konvex wird.

Die Offenlegungsschrift US 2018/087846 A1 beschreibt eine geklebte Wärmeübertragungseinheit aus unterschiedlichen Materialien. Die Baugruppe umfasst eine Rahmenkomponente, eine dünne gestanzte Komponente und mindestens eine Komponente aus einem anderen Metall, die Mittel zur Wärmeübertragung aufweist und eine höhere Wärmeleitfähigkeit hat als die Rahmenkomponente und die gestanzte Komponente. Die Wärmeübertragungsbaugruppe weist eine neuartige Geometrie auf, so dass Verformungen, die durch ungleiche Wärmeausdehnungsraten verursacht werden, die normalerweise ebene Form der Baugruppe nicht beeinträchtigen.

Die Offenlegungsschrift JP H11 31771 A beschreibt ein Verfahren zur Herstellung eines Kühlkörpers, der mit in kurzen Abständen angeordneten Rippen versehen ist.

Der Erfindung liegt die Aufgabe zugrunde, eine Entwärmung in einer Leistungsmoduleinheit zu verbessern.

Die Aufgabe wird erfindungsgemäß gelöst durch ein Verfahren zur Herstellung einer Leistungsmoduleinheit, wobei Kühlrippen in Aussparungen eines, insbesondere metallischen, Rahmens, positioniert werden, wobei mittels eines thermischen Spritzverfahrens ein erster metallischer Werkstoff auf die Kühlrippen und den Rahmen aufgebracht wird, wobei durch den aufgebrachten ersten metallischen Werkstoff eine stoffschlüssige Verbindung zwischen den Kühlrippen und dem Hilfsrahmen hergestellt wird.

Ferner wird die Aufgabe erfindungsgemäß gelöst durch einen Kühlkörper für eine Leistungsmoduleinheit mit Kühlrippen und einem, insbesondere metallischen, Rahmen, wobei die Kühlrippen in Aussparungen des, insbesondere metallischen, Rahmens, positioniert sind, wobei mittels eines thermischen Spritzverfahrens ein erster metallischer Werkstoff auf die Kühlrippen und den Rahmen aufgebracht ist, wobei durch den aufgebrachten ersten metallischen Werkstoff eine stoffschlüssige Verbindung zwischen den Kühlrippen und dem Rahmen hergestellt ist.

Überdies wird die Aufgabe erfindungsgemäß durch eine Leistungsmoduleinheit, welche mindestens einen derartigen Kühlkörper aufweist, gelöst.

Darüber hinaus wird die Aufgabe erfindungsgemäß durch einen Umrichter, welcher mindestens eine derartige Leistungsmoduleinheit aufweist, gelöst.

Die in Bezug auf das Verfahren nachstehend angeführten Vorteile und bevorzugten Ausgestaltungen lassen sich sinngemäß auf die Leistungsmoduleinheit und den Umrichter übertragen.

Der Erfindung liegt die Überlegung zugrunde, Kühlrippen über eine stoffschlüssige Verbindung zu einem Kühlkörper für eine Leistungsmoduleinheit zu verbinden, um eine optimale thermische Anbindung zu erreichen. Die stoffschlüssige Verbindung wird mittels eines thermischen Spritzverfahrens hergestellt. Ein thermisches Spritzverfahren ist ein additives Herstellungsverfahren, insbesondere ein Beschichtungsverfahren, bei dem laut der normativen Definition (DIN EN 657) Zusatzwerkstoffe, die so genannten Spritzzusätze, innerhalb oder außerhalb eines Spritzbrenners ab-, an- oder aufgeschmolzen, in einem Gasstrom in Form von Spritzpartikeln beschleunigt und auf die Oberfläche des zu beschichtenden Bauteils geschleudert werden. Die Bauteiloberfläche wird dabei, beispielsweise verglichen mit Auftragsschweißen, nicht angeschmolzen und daher nur in geringem Maße thermisch belastet. Derartige thermische Spritzverfahren sind beispielsweise Lichtbogenspritzen, Plasmaspritzen, Flammspritzen, Laserspritzen und Kaltgasspritzen. Vor dem Auftragen eines ersten metallischen Werkstoffs werden die Kühlrippen beispielsweise vertikal, das heißt hochkant, in Aussparungen eines, insbesondere metallischen, Rahmens positioniert. Der Rahmen ist beispielsweise aus Aluminium gefertigt und weist insbesondere eine kammförmige Struktur auf, wobei die Kühlrippen zwischen Zinken der kammförmigen Struktur des Rahmens angeordnet sind. Der erste metallische Werkstoff enthält beispielsweise Kupfer und/oder Aluminium, um eine möglichst große Wärmeleitfähigkeit zu gewährleisten. Der erste metallische Werkstoff wird insbesondere auf der Seite des, insbesondere kammförmigen, Rahmens aufgetragen, welche einen geringeren Überstand der Kühlrippen aufweist. Beispielsweise ist der Überstand auf einer Seite des Rahmens kleiner als 10 %, insbesondere kleiner als 5 % der Kühlrippenlänge. Durch das Auftragen des ersten metallischen Werkstoffs wird eine stoffschlüssige Verbindung zwischen den Kühlrippen und dem Hilfsrahmen hergestellt, wodurch der Kühlkörper der Leistungsmoduleinheit ausgebildet wird. Die mit dem ersten metallischen Werkstoff beschichtete Seite des Rahmens ist in einem weiteren Schritt, beispielsweise durch spanende Bearbeitung, weiter verarbeitbar. Ferner ist zumindest ein Leistungsmodul auf dem Kühlkörper anordenbar. Durch ein derartiges additives Herstellungsverfahren sind, neben einer optimalen thermischen Anbindung, vielfältige Rippen-Geometrien und Legierungen, insbesondere für die Rippen, verwendbar.

Besonders vorteilhaft werden die Kühlrippen formschlüssig im Rahmen gehalten. Durch eine formschlüssige Verbindung werden die Kühlrippen während des Auftragens des ersten metallischen Werkstoffs zuverlässig gehalten. Ferner treten, insbesondere im Vergleich zu einer Klemmverbindung, keine merklichen Verspannungen zwischen den Kühlrippen und dem Rahmen auf.

Bei einer weiteren Ausgestaltung weisen die Kühlrippen, zumindest im Bereich des Rahmens, eine Profilierung, insbesondere eine Verdickung, auf, wobei die Kühlrippen durch die Profilierung formschlüssig im Rahmen gehalten werden. Eine derartige Verdickung ist beispielsweise ein, insbesondere beidseitiger, Überstand der Kühlrippen, sodass diese zwischen den Zinken des kammförmigen Rahmens formschlüssig gehalten werden. Insbesondere ist der Überstand hammerkopfförmig ausgeführt.

In einer weiteren Ausführungsform werden die Kühlrippen lose in den Aussparungen des Rahmens positioniert und wobei die Kühlrippen auf einer dem Rahmen abgewandten Seite, insbesondere formschlüssig, fixiert werden. Eine lose Positionierung bedeutet, dass die Kühlrippen nicht kraftschlüssig, beispielsweise durch eine Klemmverbindung, im Rahmen fixiert werden. Eine lose Positionierung beinhaltet optional, dass der Rahmen die Kühlrippen zumindest teilweise, insbesondere flächig, berührt. Durch die lose Positionierung sind Toleranzen ausgleichbar. Ferner sind, insbesondere bei der Verwendung von Aluminium-Kühlrippen, stranggepresste Standardhalbzeuge verwendbar.

Bei einer weiteren Ausgestaltung werden die Kühlrippen hochkant, äquidistant und/oder parallel, nebeneinander angeordnet. Eine derartige Anordnung ist einfach und kostengünstig zu fertigen.

Besonders vorteilhaft wird der erste metallische Werkstoff mittels Kaltgasspritzen aufgesprüht. Beim Kaltgasspritzen handelt es sich um ein thermisches Spritzverfahren, wobei die Spritzpartikel auf eine so hohe Geschwindigkeit beschleunigt werden, dass sie im Gegensatz zu anderen thermischen Spritzverfahren auch ohne vorangehendes An- oder Aufschmelzen beim Aufprall auf das Substrat eine dichte und fest haftende Schicht bilden. Da das mittels Kaltgasspritzen aufgetragene Material nicht geschmolzen, sondern durch seine kinetische Energie verformt wird, ist die Bauteiloberfläche des Blechpakets, im Vergleich zu anderen thermischen Spritzverfahren, nur sehr geringen Temperaturbelastungen ausgesetzt.

In einer weiteren Ausführungsform wird durch den aufgesprühten metallischen Werkstoff eine im Wesentlichen ebene erste Oberfläche ausgebildet. Eine derartige Oberfläche ist mit weiteren Komponenten der Leistungsmoduleinheit bestückbar. Insbesondere bei einer unmittelbaren Anbindung ergeben sich sehr gute thermische Eigenschaften.

Bei einer weiteren Ausgestaltung wird nach dem Auftragen des ersten metallischen Werkstoffs eine erste Oberfläche plan abgefräst. Durch das Abfräsen wird eine sehr glatte Oberfläche erreicht, auf der weitere Komponenten der Leistungsmoduleinheit über einen weiten Temperaturbereich mechanisch stabil, insbesondere stoffschlüssig, verbindbar sind.

In einer weiteren Ausführungsform wird ein dielektrisches Substrat stoffschlüssig auf die erste Oberfläche aufgebracht. Ein derartiges dielektrisches Substrat enthält beispielsweise einen keramischen Werkstoff wie Aluminiumoxid und/oder Aluminiumnitrid. Beispielsweise wird das dielektrische Substrat gesintert und/oder geklebt. Durch eine unmittelbare stoffschlüssige Verbindung des dielektrischen Substrats mit der ersten Oberfläche wird eine optimale thermische Anbindung erreicht.

Bei einer weiteren Ausgestaltung wird ein dielektrisches Substrat mittels eines thermischen Spritzverfahrens auf die erste Oberfläche aufgebracht. Insbesondere bei der Verwendung eines gemeinsamen Werkzeugs werden Kosten gespart.

In einer weiteren Ausführungsform wird ein zweiter metallischer Werkstoff auf das dielektrische Substrat aufgebracht. Beispielsweise wird der zweite metallische Werkstoff mittels eines thermischen Spritzverfahrens aufgebracht. Insbesondere wird der zweite metallische Werkstoff mittels desselben thermischen Spritzverfahrens aufgebracht wie der erste metallische Werkstoff. Insbesondere bei der Verwendung eines gemeinsamen Werkzeugs werden Kosten gespart.

Bei einer weiteren Ausgestaltung wird nach dem Aufbringen des zweiten metallischen Werkstoffs auf das dielektrische Substrat eine zweite Oberfläche plan abgefräst. Durch das Abfräsen wird eine sehr glatte Oberfläche erreicht, auf der insbesondere Leistungshalbleiter über einen weiten Temperaturbereich mechanisch stabil, insbesondere stoffschlüssig, beispielsweise durch Löten oder Sintern, verbindbar sind.

In einer weiteren Ausführungsform sind zumindest zwei Kühlrippen derartig angeordnet, dass ein Verhältnis aus Rippenlänge zu Rippenabstand mindestens 3, insbesondere mindestens 5 beträgt. Ein derartiges Verhältnis aus Rippenlänge zu Rippenabstand ist beispielsweise durch Fräsen aus mechanischen Gründen nicht wirtschaftlich realisierbar. Durch ein derartiges Verhältnis aus Rippenlänge zu Rippenabstand ist kostengünstig eine optimale Entwärmung der Leistungsmoduleinheit erzielbar.

Im Folgenden wird die Erfindung anhand der in den Figuren dargestellten Ausführungsbeispiele näher beschrieben und erläutert.

Es zeigen:
- FIG 1: eine schematische dreidimensionale Darstellung eines Verfahrens zur Herstellung eines Kühlkörpers für eine Leistungsmoduleinheit,
- FIG 2: eine schematische dreidimensionale Darstellung eines ersten thermischen Spritzverfahrens zur Herstellung eines Kühlkörpers,
- FIG 3: eine schematische Schnittdarstellung eines zweiten thermischen Spritzverfahrens zur Herstellung eines Kühlkörpers,
- FIG 4: eine schematische Schnittdarstellung eines dritten thermischen Spritzverfahrens zur Herstellung eines Kühlkörpers,
- FIG 5: eine schematische Schnittdarstellung eines Fräsver-fahrens nach dem Auftragen des ersten metallischen Werkstoffs,
- FIG 6: eine schematische Schnittdarstellung eines Kühlkör-pers mit variabler Stärke und Abstand der Kühlrippen,
- FIG 7: eine schematische Schnittdarstellung eines Kühlkör-pers mit variablem Winkel der Kühlrippen,
- FIG 8: eine schematische Schnittdarstellung einer ersten Ausgestaltung einer Leistungsmoduleinheit und
- FIG 9: eine schematische Schnittdarstellung einer zweiten Ausgestaltung einer Leistungsmoduleinheit.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

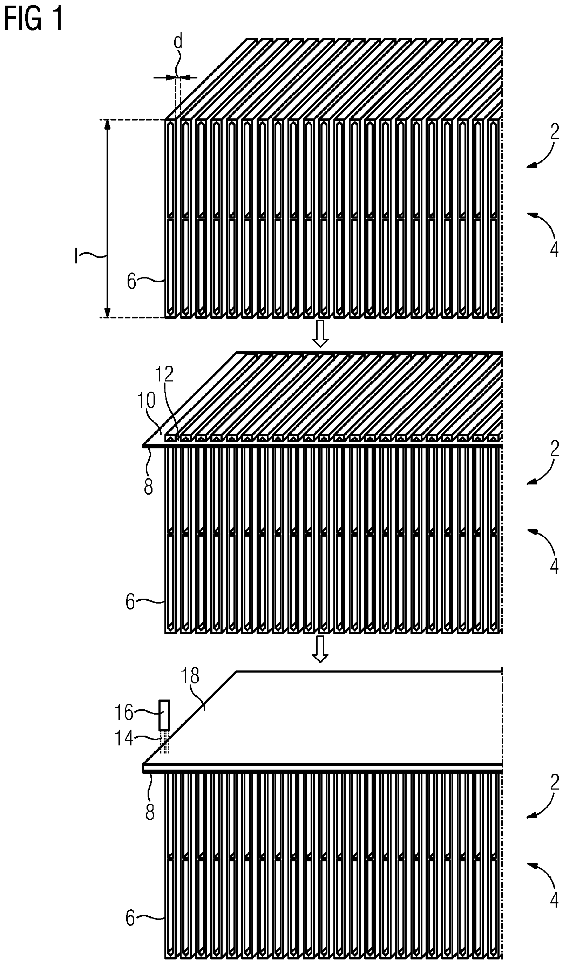

FIG 1 zeigt eine schematische dreidimensionale Darstellung eines Verfahrens zur Herstellung eines Kühlkörpers 2 für eine Leistungsmoduleinheit 4. In einem ersten Schritt werden Kühlrippen 6, welche exemplarisch als Hohlkammer-Kühlrippen ausgestaltet sind und beispielsweise aus Aluminium und/oder Kupfer mittels Strangpressen hergestellt sind, nebeneinander angeordnet. Beispielhaft sind die Kühlrippen 6 hochkant, äquidistant und parallel nebeneinander angeordnet, wobei ein Verhältnis aus Rippenlänge l zu Rippenabstand d mindestens 3, insbesondere mindestens 5 beträgt. In einem darauffolgenden Schritt wird ein, insbesondere metallischer, Rahmen 8 derartig angeordnet, dass die Kühlrippen 6 in Aussparungen 10 des Rahmens 8 angeordnet sind. Der Rahmen, der als Grundplatte fungiert, wird beispielsweise aus Aluminium gefertigt und weist insbesondere eine kammförmige Struktur auf, wobei die Kühlrippen 6 zwischen, insbesondere parallel und äquidistant verlaufenden, Zinken 12 der kammförmigen Struktur des Rahmens 8 angeordnet sind. Mittels eines thermischen Spritzverfahrens wird ein erster metallischer Werkstoff 14 auf die Kühlrippen 6 und den Rahmen 8 aufgebracht, wobei durch den aufgebrachten ersten metallischen Werkstoff 14 eine stoffschlüssige Verbindung zwischen den Kühlrippen 6 und dem Rahmen 8 hergestellt wird. Der erste metallische Werkstoff 14 enthält beispielsweise Kupfer und/oder Aluminium, um eine möglichst große Wärmeleitfähigkeit zu gewährleisten. Ein thermisches Spritzverfahrens ist ein additives Herstellungsverfahren, insbesondere ein Beschichtungsverfahren bei dem laut der normativen Definition (DIN EN 657) Zusatzwerkstoffe, die so genannten Spritzzusätze, innerhalb oder außerhalb eines Spritzbrenners ab-, an- oder aufgeschmolzen, in einem Gasstrom in Form von Spritzpartikeln beschleunigt und auf die Oberfläche des zu beschichtenden Bauteils geschleudert werden. Die Bauteiloberfläche wird dabei, beispielsweise verglichen mit Auftragsschweißen, nicht angeschmolzen und daher nur in geringem Maße thermisch belastet. Beispielsweise wird der erste metallische Werkstoff 14 mittels Kaltgasspritzen auf die Kühlrippen 6 und den Rahmen 8 aufgesprüht. Beim Kaltgasspritzen werden die Spritzpartikel durch eine Spritzvorrichtung 16, welche in FIG 1 aus Gründen der Übersichtlichkeit nur schematisch dargestellt ist, auf eine so hohe Geschwindigkeit beschleunigt, dass sie im Gegensatz zu anderen thermischen Spritzverfahren auch ohne vorangehendes An- oder Aufschmelzen beim Aufprall auf das Substrat eine dichte und fest haftende Schicht bilden. Da das mittels Kaltgasspritzen aufgetragene Material nicht geschmolzen, sondern durch seine kinetische Energie verformt wird, ist die Bauteiloberfläche des Blechpakets, im Vergleich zu anderen thermischen Spritzverfahren, nur sehr geringen Temperaturbelastungen ausgesetzt. Durch den aufgesprühten ersten metallischen Werkstoff 14 wird, neben der stoffschlüssigen Verbindung, eine im Wesentlichen ebene erste Oberfläche 18 ausgebildet. Die erste Oberfläche 18 ist in einem weiteren Schritt, beispielsweise durch spanende Bearbeitung, weiter verarbeitbar. Ferner ist zumindest ein Leistungsmodul auf der ersten Oberfläche 18 anordenbar.

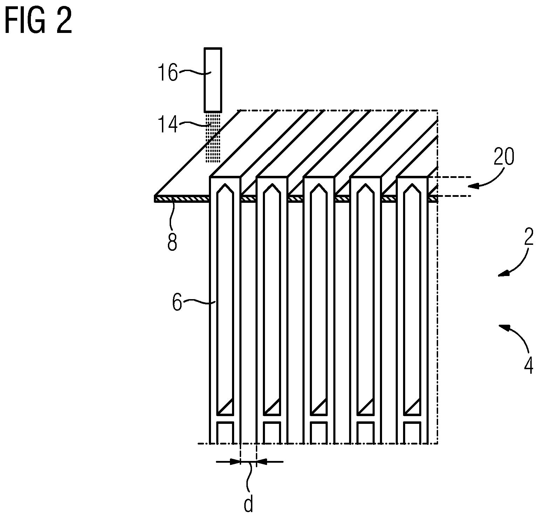

FIG 2 zeigt eine schematische dreidimensionale Darstellung eines ersten thermischen Spritzverfahrens zur Herstellung eines Kühlkörpers 2 für eine Leistungsmoduleinheit 4.

Der erste metallische Werkstoff 14 wird auf der Seite des, insbesondere kammförmigen, Rahmens 8 aufgetragen, welche einen geringeren Überstand 20 der Kühlrippen 6 aufweist. Beispielhaft ist der Überstand 20 auf einer Seite des Rahmens 8 kleiner als 10 %, insbesondere kleiner als 5 %, der Kühlrippenlänge l. Die weitere Ausführung des Herstellungsverfahrens in FIG 2 entspricht dem in FIG 1.

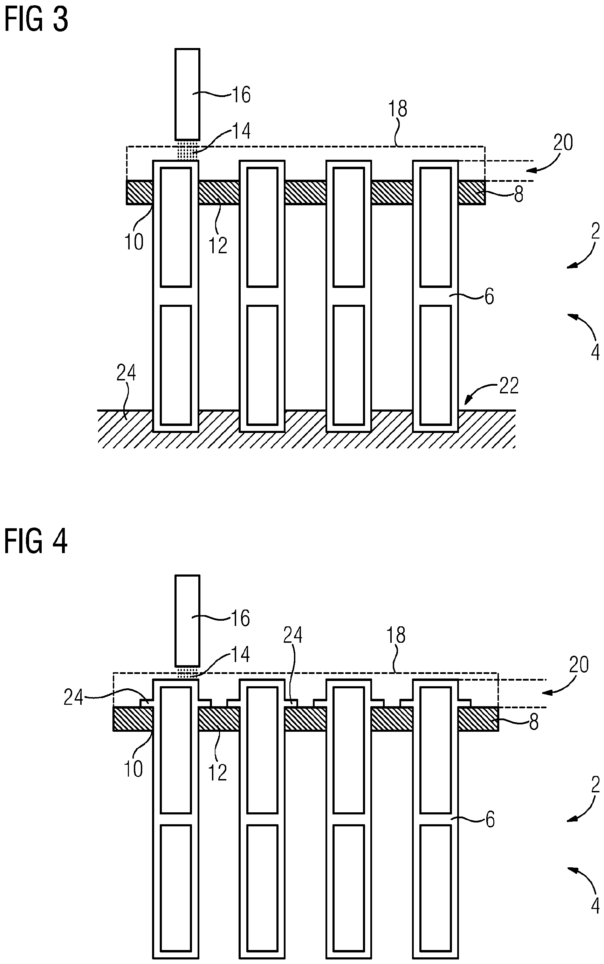

FIG 3 zeigt eine schematische Schnittdarstellung eines zweiten thermischen Spritzverfahrens zur Herstellung eines Kühlkörpers 2. Die Kühlrippen 6 sind lose in den Aussparungen 10 des Rahmens 8 angeordnet. Eine lose Positionierung bedeutet, dass die Kühlrippen 6 nicht kraftschlüssig, beispielsweise durch eine Klemmverbindung, im Rahmen 8 fixiert werden. Eine lose Positionierung beinhaltet optional, dass der Rahmen 8 die Kühlrippen 6 zumindest teilweise, insbesondere flächig, berührt. Der Rahmen 8 wird von außen horizontal gehalten, wobei eine Haltevorrichtung aus Gründen der Übersichtlichkeit nicht dargestellt wird. Die Kühlrippen 6 werden auf einer dem Rahmen 8 abgewandten Seite 22, insbesondere formschlüssig, über eine Haltevorrichtung 23 fixiert. Die weitere Ausführung des Herstellungsverfahrens in FIG 3 entspricht dem in FIG 2.

FIG 4 zeigt eine schematische Schnittdarstellung eines dritten thermischen Spritzverfahrens zur Herstellung eines Kühlkörpers 2. Die Kühlrippen 6 weisen im Bereich des Rahmens 8, eine Profilierung 24 auf. Die Profilierung 24 ist exemplarisch als Verdickung ausgeführt, durch welchen die Kühlrippen 6 formschlüssig im Rahmen 8 gehalten werden. Eine derartige beidseitige Verdickung der Kühlrippen 6 ist exemplarisch hammerkopfförmig ausgeführt, sodass diese zwischen den Zinken 12 des kammförmigen Rahmens 8 formschlüssig gehalten werden. Die weitere Ausführung des Herstellungsverfahrens in FIG 4 entspricht dem in FIG 2.

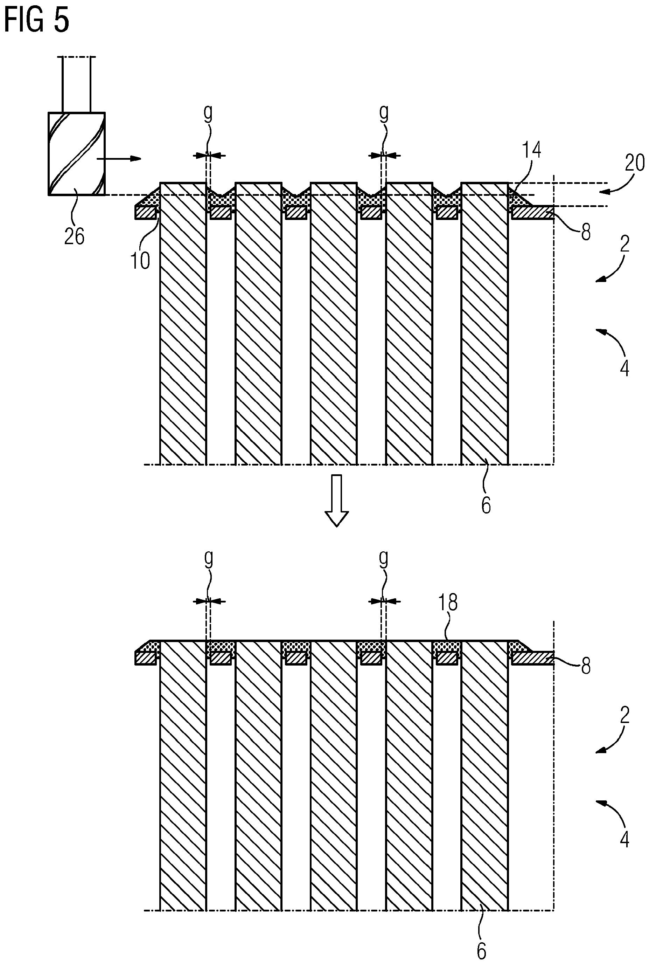

FIG 5 zeigt eine schematische Schnittdarstellung eines Fräsverfahrens nach dem Auftragen des ersten metallischen Werkstoffs. Die Kühlrippen 6 sind lose in den Aussparungen 10 des Rahmens 8 angeordnet und stoffschlüssig über den ersten metallischen Werkstoff 14 miteinander verbunden. Zwischen den Kühlrippen 6 und dem Rahmen 8 befindet sich, insbesondere beidseitig, ein Spalt g, welcher eine Breite im µm-Breich aufweist. Der Spalt g wird zumindest teilweise durch den ersten metallischen Werkstoff 14 aufgefüllt, wobei das Auffüllen durch Schrägstellung der Spritzvorrichtung 16 während des Spritzvorgangs erzielt wird. Der erste metallische Werkstoff 14 ist aus Kostengründen möglichst sparsam aufgetragen, wobei eine glatte erste Oberfläche 18 durch horizontales Abfräsen mittels einer Fräsvorrichtung 26 erreicht wird. Die weitere Ausführung des Herstellungsverfahrens in FIG 5 entspricht dem in FIG 2.

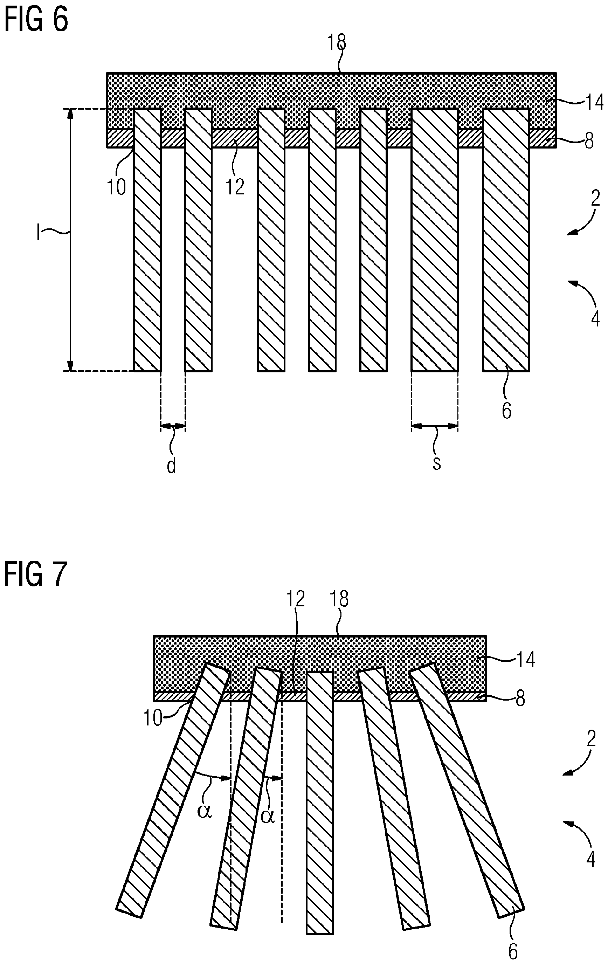

FIG 6 zeigt eine schematische Schnittdarstellung eines Kühlkörpers 2 mit variabler Stärke s und Abstand d der Kühlrippen 6. Die Kühlrippen sind exemplarisch massiv ausgeführt. Ein Verhältnis aus Rippenlänge l zu minimalem Rippenabstand d beträgt mindestens 3, insbesondere mindestens 5. Die weitere Ausführung des Kühlkörpers 2 entspricht der aus FIG 1.

FIG 7 zeigt eine schematische Schnittdarstellung eines Kühlkörpers 2 mit variablem Winkel α der Kühlrippen. Insbesondere nimmt der Winkel α zu den Rändern des Kühlkörpers hin ab, sodass eine bessere Entwärmung im mittleren Bereich stattfindet. Die weitere Ausführung des Kühlkörpers 2 entspricht der aus FIG 1.

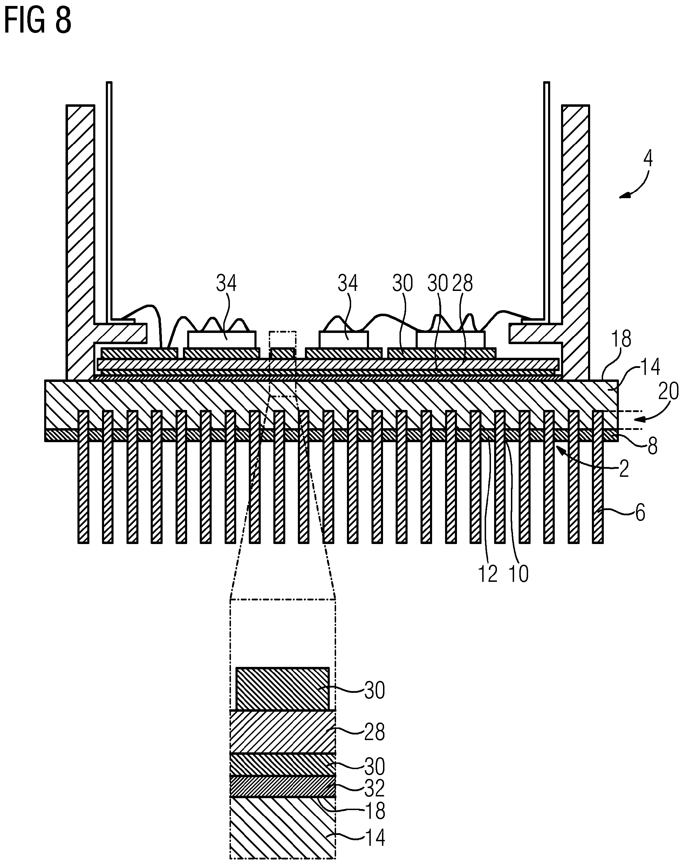

FIG 8 zeigt eine schematische Schnittdarstellung einer ersten Ausgestaltung einer Leistungsmoduleinheit 4 mit einem moduleigenen Kühlkörper 2. Beispielhaft enthalten die Kühlrippen 6 des Kühlkörpers 2 Aluminium und sind hochkant, äquidistant und parallel nebeneinander angeordnet. Die Kühlrippen 6 sind in Aussparungen 10 des Rahmens 8, der als Grundplatte fungiert, angeordnet. Der Rahmen 8 ist aus Aluminium gefertigt und weist eine kammförmige Struktur auf, wobei die Kühlrippen 6 zwischen den, insbesondere parallel und äquidistant verlaufenden, Zinken 12 der kammförmigen Struktur des Rahmens 8 angeordnet sind. Der erste metallische Werkstoff 14, welcher mittels eines thermischen Spritzverfahrens, insbesondere mittels Kaltgasspritzen, aufgetragen ist, und die Kühlrippen 6 und den Rahmen 8 stoffschlüssig verbindet und die erste Oberfläche 18 ausbildet, enthält Kupfer, um eine möglichst thermische Anbindung zu gewährleisten. Die weitere Ausgestaltung des Kühlkörpers 2 in FIG 8 entspricht der in FIG 1. Die erste Oberfläche 18 ist optional durch Abfräsen geglättet. Ein dielektrisches Substrat 28 wird mit der ersten Oberfläche 18 des Kühlkörpers 2, beispielsweise mittels Löten, Sintern oder Kleben, insbesondere stoffschlüssig, verbunden. Das dielektrische Substrat 28 ist beispielsweise aus einem keramischen Werkstoff, insbesondere aus Aluminiumoxid oder Aluminiumnitrid, hergestellt und umfasst beidseitige zumindest teilweise strukturierte Kupferlagen 30. Über eine Verbindungsschicht 32, beispielsweise eine Lotschicht, ist eine Kupferlage 30 des dielektrischen Substrats 28 mit dem Kühlkörper, insbesondere stoffschlüssig, verbunden. Auf der dem Kühlkörper 2 abgewandten Seite des dielektrischen Substrats 28 sind Leistungshalbleiter 34 auf eine strukturierte Kupferlage 30 des dielektrischen Substrats 28, beispielsweise mittels Löten oder Sintern, aufgebracht.

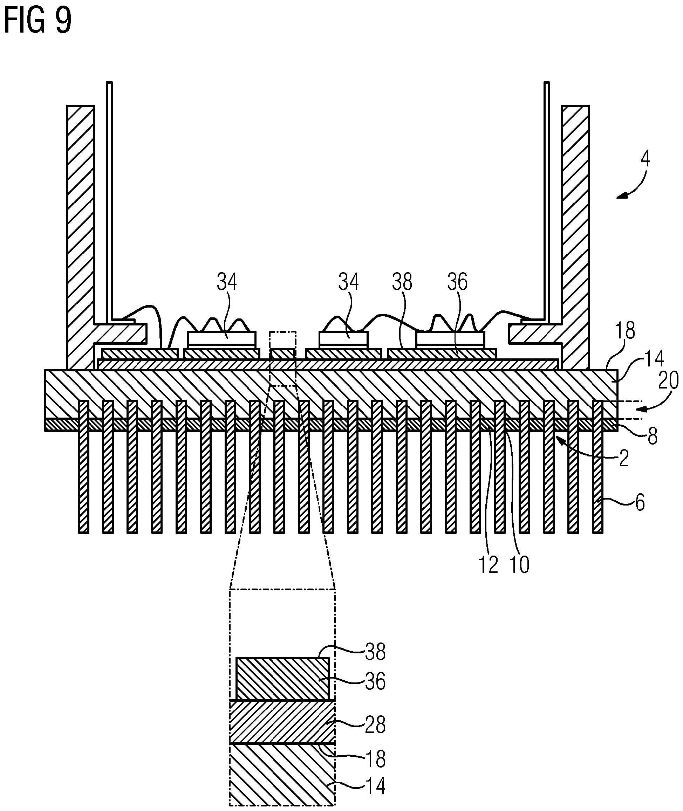

FIG 9 zeigt eine schematische Schnittdarstellung einer zweiten Ausgestaltung einer Leistungsmoduleinheit 4 mit einem moduleigenen Kühlkörper 2. Auf die erste Oberfläche 18 ist ein dielektrisches Substrat 28 mittels eines thermischen Spritzverfahrens, insbesondere mittels Kaltgasspritzen, aufgebracht. Das dielektrische Substrat 28 enthält insbesondere Mikropartikel aus einem keramischen Werkstoff. Beispielsweise werden Aluminiumoxid- oder Aluminiumnitrid-Mikropartikel mittels Kaltgasspritzen aufgesprüht. Durch das thermische Spritzverfahren ist das dielektrische Substrat 28 unmittelbar mit der ersten Oberfläche 18 verbunden, sodass keine zusätzliche Kupferlage 30 und keine Verbindungsschicht 32 erforderlich sind. Auf das dielektrische Substrat 28 wird ein zweiter metallischer Werkstoff 36, welcher beispielsweise Kupfer-Mikropartikel aufweist, direkt mittels eines thermischen Spritzverfahrens, insbesondere mittels Kaltgasspritzen, aufgebracht. Eine Strukturierung erfolgt additiv durch Aussparung während des Spritzverfahrens oder subtraktiv, beispielsweise durch Abfräsen. Insbesondere wird der zweite metallische Werkstoff 36 mittels desselben thermischen Spritzverfahrens aufgebracht wie der erste metallische Werkstoff 14 und oder das dielektrische Substrat 28. Insbesondere bei der Verwendung eines gemeinsamen Werkzeugs werden Kosten gespart. Nach dem Aufbringen des zweiten metallischen Werkstoffs 36 auf das dielektrische Substrat 28 wird optional eine zweite Oberfläche 38 plan abgefräst. Auf die strukturierte zweite Oberfläche 38 werden Leistungshalbleiter 34, beispielsweise mittels Löten oder Sintern, aufgebracht. Die weitere Ausführung der Leistungsmoduleinheit 4 entspricht der aus FIG 8.

Zusammenfassend betrifft die Erfindung ein Verfahren zur Herstellung einer Leistungsmoduleinheit 4. Um eine Entwärmung der Leistungsmoduleinheit 4 zu verbessern wird vorgeschlagen, dass Kühlrippen 6 in Aussparungen 10 eines, insbesondere metallischen, Rahmens 8, positioniert werden, wobei mittels eines thermischen Spritzverfahrens ein erster metallischer Werkstoff 14 auf die Kühlrippen 6 und den Rahmen 8 aufgebracht wird, wobei durch den aufgebrachten ersten metallischen Werkstoff 14 eine stoffschlüssige Verbindung zwischen den Kühlrippen 6 und dem Rahmen 8 hergestellt wird.

## Patentansprüche

1. Verfahren zur Herstellung einer Leistungsmoduleinheit (4), wobei Kühlrippen (6) in Aussparungen (10) eines, insbesondere metallischen, Rahmens (8), positioniert werden,
**dadurch gekennzeichnet, dass**
mittels eines thermischen Spritzverfahrens ein erster metallischer Werkstoff (14) auf die Kühlrippen (6) und den Rahmen (8) aufgebracht wird,
wobei durch den aufgebrachten ersten metallischen Werkstoff (14) eine stoffschlüssige Verbindung zwischen den Kühlrippen (6) und dem Rahmen (8) hergestellt wird.

2. Verfahren nach Anspruch 1,
wobei die Kühlrippen (6) formschlüssig im Rahmen (8) gehalten werden.

3. Verfahren nach einem der vorherigen Ansprüche,
wobei die Kühlrippen (6), zumindest im Bereich des Rahmens (8), eine Profilierung (24), insbesondere eine Verdickung, aufweisen,
wobei die Kühlrippen (6) durch die Profilierung (24) formschlüssig im Rahmen (8) gehalten werden.

4. Verfahren nach Anspruch 1,
wobei die die Kühlrippen (6) lose in den Aussparungen (10) des Rahmens (8) positioniert werden und
wobei die Kühlrippen (6) auf einer dem Rahmen (8) abgewandten Seite (22), insbesondere formschlüssig, fixiert werden.

5. Verfahren nach einem der vorherigen Ansprüche,
wobei die Kühlrippen (6) hochkant, äquidistant und/oder parallel, nebeneinander angeordnet werden.

6. Verfahren nach einem der vorherigen Ansprüche,
wobei der erste metallische Werkstoff (14) mittels Kaltgasspritzen aufgesprüht wird.

7. Verfahren nach einem der vorherigen Ansprüche,
wobei durch den aufgesprühten ersten metallischen Werkstoff (14) eine im Wesentlichen ebene erste Oberfläche (18) ausgebildet wird.

8. Verfahren nach einem der vorherigen Ansprüche,
wobei nach dem Auftragen des ersten metallischen Werkstoffs (14) eine erste Oberfläche (18) plan abgefräst wird.

9. Verfahren nach einem der Ansprüche 7 oder 8,
wobei ein dielektrisches Substrat (28) stoffschlüssig auf die erste Oberfläche (18) aufgebracht wird.

10. Verfahren nach einem der Ansprüche 7 bis 9,
wobei ein dielektrisches Substrat (28) mittels eines thermischen Spritzverfahrens auf die erste Oberfläche (18) aufgebracht wird.

11. Verfahren nach einem der Ansprüche 9 oder 10,
wobei ein zweiter metallischer Werkstoff (36) auf das dielektrische Substrat (28) aufgebracht wird.

12. Verfahren nach Anspruch 11,
wobei nach dem Aufbringen des zweiten metallischen Werkstoffs (36) auf das dielektrische Substrat (28) eine zweite Oberfläche (38) plan abgefräst wird.

13. Kühlkörper (2) für eine Leistungsmoduleinheit (4) mit Kühlrippen (6) und einem, insbesondere metallischen, Rahmen (8),
wobei die Kühlrippen (6) in Aussparungen (10) des, insbesondere metallischen, Rahmens (8), positioniert sind,
**dadurch gekennzeichnet, dass**
mittels eines thermischen Spritzverfahrens ein erster metallischer Werkstoff (14) auf die Kühlrippen (6) und den Rahmen (8) aufgebracht ist,
wobei durch den aufgebrachten ersten metallischen Werkstoff (14) eine stoffschlüssige Verbindung zwischen den Kühlrippen (6) und dem Rahmen (8) hergestellt ist.

14. Kühlkörper (2) nach Anspruch 13,
wobei zumindest zwei Kühlrippen (8) derartig angeordnet sind, dass ein Verhältnis aus Rippenlänge (1) zu Rippenabstand (d) mindestens 3, insbesondere mindestens 5 beträgt.

15. Leistungsmoduleinheit (4), welche mindestens einen Kühlkörper (2) nach einem der Ansprüche 13 oder 14 aufweist.

16. Umrichter, welcher mindestens eine Leistungsmoduleinheit (4) nach Anspruch 15 aufweist.

## Claims

1. Method of manufacturing a power module unit (4),
wherein cooling fins (6) are positioned in recesses (10) of a frame (8), in particular a metal frame (8),
**characterised in that**
a first metallic material (14) is applied to the cooling fins (6) and the frame (8) by means of a thermal spraying process, wherein the applied first metallic material (14) produces a material bond between the cooling fins (6) and the frame (8).

2. Method according to claim 1,
wherein the cooling fins (6) are retained in the frame (8) in a form-fitting manner.

3. Method according to one of the preceding claims,
wherein, at least in the region of the frame (8), the cooling fins (6) have a profiling (24), in particular a thickening,
wherein the cooling fins (6) are retained in the frame (8) in a form-fitting manner by the profiling (24).

4. Method according to claim 1,
wherein the cooling fins (6) are loosely positioned in the recesses (10) of the frame (8), and
wherein the cooling fins (6) are fixed, in particular in a form-fitting manner, on a side (22) facing away from the frame (8) .

5. Method according to one of the preceding claims,
wherein the cooling fins (6) are disposed upright,
equidistantly and/or parallel to one another.

6. Method according to one of the preceding claims,
wherein the first metallic material (14) is applied by cold spraying.

7. Method according to one of the preceding claims,
wherein an essentially planar first surface (18) is formed by the sprayed-on first metallic material (14).

8. Method according to one of the preceding claims,
wherein after the first metallic material (14) has been applied, a first surface (18) is milled off flat.

9. Method according to one of claims 7 or 8,
wherein a dielectric substrate (28) is applied to the first surface (18) in a materially bonded manner.

10. Method according to one of claims 7 to 9,
wherein a dielectric substrate (28) is applied to the first surface (18) by means of a thermal spraying process.

11. Method according to one of claims 9 or 10,
wherein a second metallic material (36) is applied to the dielectric substrate (28).

12. Method according to claim 11,
wherein after applying the second metallic material (36) to the dielectric substrate (28), a second surface (38) is milled off flat.

13. Heat sink (2) for a power module unit (4), comprising
cooling fins (6) and a frame (8), in particular a metal frame (8),
wherein the cooling fins (6) are positioned in recesses (10) of the, in particular, metal frame (8),
**characterised in that**
a first metallic material (14) is applied to the cooling fins (6) and the frame (8) by means of a thermal spraying process, wherein a material bond is produced between the cooling fins (6) and the frame (8) by means of the applied first metallic material (14).

14. Heat sink (2) according to claim 13,
wherein at least two cooling fins (8) are disposed such that a ratio of fin length (1) to fin spacing (d) is at least 3, in particular at least 5.

15. Power module unit (4) having at least one heat sink (2) according to one of claims 13 or 14.

16. Converter having at least one power module unit (4) according to claim 15.

## Revendications

1. Procédé de fabrication d'une unité (4) de module de puissance, dans lequel on met en position des ailettes (6) de refroidissement dans des évidements (10) d'un cadre (8), en particulier métallique,
**caractérisé en ce que**
l'on dépose, au moyen d'un procédé de pulvérisation thermique, un premier matériau (14) métallique sur les ailettes (6) de refroidissement et le cadre (8),
dans lequel, par le premier matériau (14) métallique déposé, on produit une liaison à coopération de matière entre les ailettes (6) de refroidissement et le cadre (8).

2. Procédé suivant la revendication 1,
dans lequel on maintient les ailettes (6) de refroidissement à complémentarité de forme dans le cadre (8).

3. Procédé suivant l'une des revendications précédentes,
dans lequel les ailettes (6) de refroidissement ont, du moins dans la partie du cadre (8), un profilage (24), en particulier un épaississement,
dans lequel on maintient les ailettes (6) de refroidissement à complémentarité de forme dans le cadre (8) par le profilage (24).

4. Procédé suivant la revendication 1,
dans lequel on met les ailettes (6) de refroidissement en position de manière lâche dans les évidements (10) du cadre (8), et
dans lequel on immobilise, en particulier à complémentarité de forme, les ailettes (6) de refroidissement d'un côté (22), non tourné vers le cadre (8).

5. Procédé suivant l'une des revendications précédentes,
dans lequel on met les ailettes (6) de refroidissement les unes à côté des autres debout, de manière équidistante et/ou parallèle.

6. Procédé suivant l'une des revendications précédentes,
dans lequel on pulvérise le premier matériau (14) métallique au moyen d'une pulvérisation au gaz froid.

7. Procédé suivant l'une des revendications précédentes,
dans lequel on forme, par le premier matériau (14) métallique pulvérisé, une première surface (18) sensiblement plane.

8. Procédé suivant l'une des revendications précédentes,
dans lequel, après le dépôt du premier matériau (14) métallique, on fraise une première surface (18) en la rendant plane.

9. Procédé suivant l'une des revendications 7 ou 8,
dans lequel on dépose un substrat (28) diélectrique et coopération de matière sur la première surface (18).

10. Procédé suivant l'une des revendications 7 à 9,
dans lequel on dépose sur la première surface (18) un substrat (28) diélectrique au moyen d'un procédé de pulvérisation thermique.

11. Procédé suivant l'une des revendications 9 ou 10,
dans lequel on dépose un deuxième matériau (36) métallique sur le substrat (28) diélectrique.

12. Procédé suivant la revendication 11,
dans lequel, après le dépôt du deuxième matériau (36) métallique sur le substrat (28) diélectrique, on fraise une deuxième surface (38) en la rendant plane.

13. Refroidisseur (2) d'une unité (4) de module de puissance, comprenant des ailettes (6) de refroidissement et un cadre (8), en particulier métallique,
dans lequel les ailettes (6) de refroidissement sont mises en position dans des évidements (10) du cadre (8), en particulier métallique,
**caractérisé en ce que**
un premier matériau (14) métallique est déposé sur les ailettes (6) de refroidissement et sur le cadre (8), au moyen d'un procédé de pulvérisation thermique,
dans lequel, par le premier matériau (14) métallique déposé, une liaison à coopération de matière est produite entre les ailettes (6) de refroidissement et le cadre (8).

14. Refroidisseur (2) suivant la revendication 13,
dans lequel au moins deux ailettes (8) de refroidissement sont disposées de manière à ce qu'un rapport de la longueur (1) des ailettes à la distance (d) entre les ailettes soit d'au moins 3, en particulier d'au moins 5.

15. Unité (4) de module de puissance, qui a au moins un refroidisseur (2) suivant l'une des revendications 13 ou 14.

16. Onduleur, qui a au moins une unité (4) de module de puissance suivant la revendication 15.
